Europäisches Patentamt

(19) European Patent Office

Office européen des brevets

(11) Publication number: **0 285 392**
**A2**

(12) # EUROPEAN PATENT APPLICATION

(21) Application number: 88302830.0

(51) Int. Cl.⁴: **H 01 L 39/24**

(22) Date of filing: 30.03.88

(30) Priority: 30.03.87 US 32414   06.04.87 US 34867
30.04.87 US 44939

(43) Date of publication of application:
05.10.88 Bulletin 88/40

(84) Designated Contracting States: DE FR GB

(71) Applicant: Hewlett-Packard Company
3000 Hanover Street
Palo Alto California 94304 (US)

(72) Inventor: Anderson, John T.
20265 Skyline Blvd.
Woodside, CA 94062 (US)

Dicarolis, Stephen A.
2122 Cabrillo Avenue
Santa Clara, CA 95050 (US)

Ruby, Richard C.
567 9th Avenue
Menlo Park CA 94025 (US)

Miller, Daniel J.
10 A Second Street
Sausalito, CA 94965 (US)

Nagesh, V. K.
20276 Pinntage Parkway
Cupertino, CA 95014 (US)

(74) Representative: Colgan, Stephen James et al
CARPMAELS & RANSFORD 43 Bloomsbury Square
London WC1A 2RA. (GB)

(54) **Methods for making superconductor precursor.**

(57) A method for making superconductor precursor including the steps of making a solution of superconductor precursor components, mixing a precipitating agent into the solution to precipitate the superconductor precursor components, filtering the components from the solution, and sintering the filtered components to form the superconductor precursor. The precursor components can be nitrated or chloride forms, in which case the components are dissolved in distilled water, or can be oxides, in which case the components are dissolved in dilute nitric acid. An oxalic acid or oxalate is used to precipitate the components from the solution.

EP 0 285 392 A2

**Description**

## METHOD FOR MAKING SUPERCONDUCTOR PRECURSOR

### BACKGROUND OF THE INVENTION

#### 1. Field of the Invention

This invention relates generally to superconductors and more particularly to the manufacture of high $T_c$ superconductor materials.

#### 2. Description of the Related Art

Superconductivity is a well-known phenomenon. For example, K. H. Onnes, as early as 1911, demonstrated that the resistance of mercury drops to zero when it is cooled to approximately 4° Kelvin (K).

Superconductivity has many potential uses. For example, superconducting power lines can save a great deal of energy which is otherwise dissipated during transmission. Superconducting magnets, generators, and motors, can be made small and extremely powerful. Superconducting devices known as Josephson junctions are extremely fast electronic switches having very low power consumption. In short, the potential uses for superconducting materials are so many and varied, that a list of possible applications can continue almost ad infinitum.

Despite all of the potential benefits of superconducting devices and structures, they have heretobefore been rarely found outside of research laboratories. A major reason for this is that it is difficult and expensive to cool most materials to their superconducting transition temperature ($T_c$) because most materials have a transition temperature within a few degrees K of absolute zero, requiring a liquid helium coolant. Unfortunately, the high costs of producing and maintaining liquid helium systems made superconductors prohibitive for most applications.

Recently, researchers announced a high $T_c$ superconductor in the article "Superconductivity at 93 K in a New Mixed-Phase Y-Ba-Cu-O Compound System at Ambient Pressure", Wu et al., Physical Review Letters, March 2, 1987, Volume 58, Number 9. This announcement caused considerable excitement in the scientific community because, for the first time, a material had been discovered having a $T_c$ which was higher than the temperature of liquid nitrogen. Since liquid nitrogen cooling systems are at least an order of magnitude less expensive than liquid helium cooling systems, many applications for superconductors suddenly became practical after this discovery.

To date, YBaCuO has been prepared from mixtures of high purity $Y_2O_3$, $BaCO_3$, and $CuO$ powders. The substantially insoluble powders were mixed in a binder (such as methanol or water) to form a colloidal suspension, ball milled, and subsequently heated to 100° C to evaporate the binder. The resultant mixture was then heated for six hours in air at 850° C to produce a semiconductor precursor which, in turn, was heated for an additional six hours at approximately 1000° C to become a superconductor material. A detailed explanation on of the method steps involved in the manufacture of superconducting YBaCuO and a description of some of its properties can be found in a paper entitled "Superconductivity and Magnetism in High-$T_c$ Superconductor YBaCuO", J. Z. Sun. et al., Department of Applied Physics, Stanford University, PACS #: 74.30.-E, 74.70.-B.

A problem with the above-described method for producing YBaCuO superconductor precursor is that the various components were not well mixed at the molecular level. In other words, even though the proportions of the various superconductor components: are correct at the macroscopic level, the components are not homogeneously mixed and distributed at the molecular level. The heterogenous mixtures produced by the above-described method results in YBaCuO superconductor materials that are of uneven quality and which include substantial non-superconductor fractions.

### SUMMARY OF THE INVENTION

A major object of this invention is to produce high quality superconductor precursors.

Briefly, the method of the present invention includes the steps of dissolving a plurality of superconductor precursor components in a solvent, mixing a precipitating agent into the resultant solution to cause the superconductor precursor components to precipitate out of the solution, washing and drying the precipitate, and then sintering the precipitate to form high quality superconductor precursor.

Because the superconductor precursor components were in solution, the various components were substantially uniformly mixed down to the molecular level. This uniform and homogeneous mixing of the components is maintained after the precipitation of the components from the solution.

An advantage of this invention is that the superconductor precursor components are very uniformly mixed, resulting in a very high quality superconductor precursor.

Another advantage of this invention is that superconductors can be produced having only a small amount of non-superconductor phases.

These and other objects and advantages of the present invention will become apparent to those skilled in the art after reading the following descriptions and studying the various figures of the drawing.

### DETAILED DESCRIPTION OF THE PREFERRED EMBODIMENTS

The preferred embodiments of the present invention will be discussed in terms of the new YBaCuO class of high temperature superconductors that were discovered by Wu, et al., supra. However, it should be apparent to those skilled in the art that the methods and structures described herein could be practiced with a wide variety of superconducting materials, many of which are yet to be discovered.

The method of the present invention has points of similarity with the solvent-gel ("sol-gel") process for mixing chemical compounds. A description of the sol-gel process can be found in an article by Bednorz et al. in the Material Research Bulletin, 18(2), 181 (1983). The use of a sol-gel process is alluded to in "Possible High $T_c$ Superconductivity in the BaLaCuO System", Bednorz et al., Z. Phys. B, Condensed Matter 64, 189, 193 (1986).

The basic method for making superconductor precursor in accordance with the present invention includes the steps of dissolving soluble forms of superconductor precursor components in a suitable solution, and then mixing in a precipitating agent to cause the superconductor precursor components to precipitate out of the solution. Suitable soluble forms of the superconductor precursor components include soluble nitrates and chlorides. The precipitated superconductor precursor components are then filtered from the solution, washed, and dried. Finally, the components are sintered to form the superconductor precursor.

A first specific method for making YBaCuO superconductor precursor in accordance with the present invention involves the use of soluble forms of the precursor components yttrium (Y), barium (Ba), and copper (Cu). Commercially available soluble forms of Y, Ba, and Cu include the nitrated forms of these elements (i.e. $Y(NO_3)_3$, $Ba(NO_3)_2$, $Cu(NO_3)$) and the chloride forms of these elements (i.e. $YCl_3$, $BaCl_2$, $CuCl_2$). The chosen soluble forms of the Y, Ba, and Cu are then dissolved in distilled water according to the appropriate stoichiometry.

To precipitate the superconductor precursor components from the resultant solution, 10% oxalic acid ($H_2C_2O_4$) is rapidly mixed into the solution. There should be an approximately five-fold molar excess of oxalic acid to precursor components.

The pH of the solution after the oxalic acid is introduced should be maintained above 2.0 to prevent the precipitated oxalates from re-dissolving. The pH of the solution can be adjusted by the addition of small amounts of ammonium hydroxide ($NH_3OH$), or other bases which do not cause metal contamination.

The solution should be stirred at room temperature or below (in, for example, an ice bath) for approximately one hour after the oxalic acid is added to maximize precipitate formation. The resulting precipitate includes oxalates of the of the precursor components such as $Y_2(C_2O_4) \cdot 3H_2O$, $BaC_2O_4$, and $CuC_2O_4$.

Next, the precipitate is filtered from the solution, and washed four or five times in distilled water. After the precipitate has been air dried and formed into a loose cake, it is placed in an air oven and calcined at between 800°-1000° C to eliminate the carbon and oxidize the precursor components. The resultant superconductor precursor powder includes $Y_2O_3$, BaO, and CuO which are homogeneously mixed to the correct ratios at the molecular level.

A second specific method for making superconductor precursor in accordance with the present invention also starts with commercially available soluble forms of the superconductor precursor components, in this case oxides of Y, Ba, and Cu such as $Y_2O_3$, BaO, and CuO. The oxides are then dissolved in dilute nitric acid ($HNO_3$) to form a solution, which is then neutralized to a pH of between 6 and 8 by the addition of sodium hydroxide (NaOH).

Next, a sodium oxalate ($Na_2C_2O_4$) or a sodium hydrogen oxalate ($NaHC_2O_4 \cdot H_2O$) is added to the neutralized solution to precipitate out the superconductor precursor components. The precipitate is then filtered, rinsed four or five times in distilled water, and calcined as described above.

Once the superconductor precursor has been made as described above, it can be used in the manufacture of superconductor precursor inks or superconductor inks. These inks have many thick-film applications, as is discussed in greater detail in copending U.S. patent application No. 032414, filed March 30, 1987 on behalf of Ruby et al. and entitled "Superconductor Inks, Thick Film Structures, and Methods for Making Same".

To produce a superconductor precursor ink, the superconductor precursor is powdered and then mixed with a liquid, organic binder, such as terpineol. To produce a superconductor ink, the superconductor precursor is first heated in an air oven above the conversion threshold temperature to convert the precursor into a superconductor, and then mixed with a liquid organic binder, such as terpineol. The inks can be silk screened, painted, drawn, sprayed, etc. onto substrates.

The superconductor precursor can also be used to make superconductor wires, as is discussed in greater detail in copending U.S. patent application No. 034867, filed April 6, 1987 on behalf of Nagesh et al. and entitled "Superconductor Wires, Capillaries, Cables, and Methods for Making Same". To produce a superconductor wire, precursor is placed into a press to form a rod-like preform. If the preform was cold pressed, it is then sintered at temperatures of approximately 950-1100° C to cause the transformation of the superconductor precursor into a superconductor. The superconductor preform is then suspended within an oven so that a portion of the preform can be heated to approximately its melting point, and the partially molten preform is drawn into a superconductor wire.

It should be noted that the above described wire-making method can produce either solid wire or hollow wire (capillary). To form solid wire, a solid preform is used. To form capillary, a hollow preform (i.e. one having a substantially annular cross-section) is used. A description of how to make capillaries from preforms can be found in U.S. patent number 4,293,415 of Bente, III et al.; in "Optical Transmission in Liquid Core Quartz Fibers", by Stone, Applied Physics, April 1972, PP. 78-79; and in "Construction of Long Lengths of Coiled Glass Capillary" by Desty et al., Analytical Chemistry, vol. 32, no. 2, Feb. 1960, pp. 302-304.

The superconductor precursor or superconductor material formed therefrom can be applied to a variety of flat and curved substrates by a thermal spraying technique, which is also referred to as flame or plasma spraying. A number of publications teach thermal spraying techniques for ceramic materials, such as "Thermal Spraying of Ceramics", by P. Chagnon, Ceram. Int. (Italy) vol. 10, no. 4; "The Present Situation of Plasma Jet Spraying", by H. Nagasaka, Oyo Buturi (Japan), vol. 52. no. 10 (1983); and "Recent Developments in Plasma Spraying", by B.R. Wallace, Colloquium on Plasma Processing and Heating Applications, 23 May 1979.

While this invention has been described with reference to several preferred embodiments, it is contemplated that various alterations and permutations of the invention will become apparent to those skilled in the art upon a reading of the preceding descriptions and a study of the drawing. It is therefore intended that the scope of the present invention be determined by the following appended claims.

## Claims

1. A method for making superconductor material characterized by the steps of:

dissolving a plurality of superconductor precursor compounds chosen from the group including soluble nitrates and soluble chlorides in a solvent;

mixing a precipitation agent into the resultant solution to cause the formation of a finely-mixed precipitate of superconductor precursor compounds; and

heating said precipitate to create superconductor material by a high-temperature, solid-state reaction.

2. A method as claimed in claim 1 wherein said solvent includes water, and wherein said precipitating agent includes an acid such as an oxalic acid ($H_2C_2O_4$).

3. A method as claimed in claim 1 wherein said superconductor precursor compounds include oxides of the superconductor elements, and wherein said solvent includes an acid such as nitric acid.

4. A method as claimed in claim 3 further characterized by the step of adding a neutralizing agent such as sodium hydroxide (NaOH) to the resultant acid solution.

5. A method as claimed in claim 3 wherein said precipitating agent includes an oxalate such as sodium oxalate ($Na_2C_2O_4$) or sodium hydrogen oxalate ($NaH_2O_4 \cdot H_2O$).

6. A method as claimed in claim 1 further characterized by the step of filtering said precipitate from solution.